## Europäisches Patentamt
## European Patent Office
## Office européen des brevets

(11) Veröffentlichungsnummer: **0 233 511**

**A1**

(12) # EUROPÄISCHE PATENTANMELDUNG

(21) Anmeldenummer: 87101036.9

(51) Int. Cl.³: **G 01 R 1/073**

(22) Anmeldetag: 26.01.87

(30) Priorität: 27.01.86 DE 3602334

(43) Veröffentlichungstag der Anmeldung:
26.08.87 Patentblatt 87/35

(84) Benannte Vertragsstaaten:
AT CH DE FR GB IT LI NL

(71) Anmelder: Feinmetall Gesellschaft mit beschränkter Haftung
Zeppelinstrasse 2
D-7033 Herrenberg(DE)

(72) Erfinder: Krüger, Gustav, Dr.
Danziger Strasse 1
D-7033 Herrenberg(DE)

(74) Vertreter: König, Oskar, Dr.-Ing. Dipl.-Phys.
Klüpfelstrasse 6 Postfach 51
D-7000 Stuttgart 1(DE)

(54) Prüfeinrichtung zur Wafer-Prüfung.

(57) Prüfeinrichtung zum Prüfen von Chips aufweisende Wafers (35) auf elektrische Fehlerfreiheit der Chips. Sie weist eine an einem Prüfkopf (29) angeordnete Nadelanordnung auf, deren Nadeln (39) die an einem jeweils zu prüfenden Chip angeordneten Pads (37) mit ihren freien Kontaktenden (41) gleichzeitig kontaktieren können. Die Nadeln (39) sind am Prüfkopf (29) ungefähr senkrecht zur Ebene des jeweils zur prüfenden Wafers (35) gerichtet. Benachbart ihren Kontaktenden (41) sind sie entsprechend den von ihnen jeweils gleichzeitig zu kontaktierenden Pads (37) angeordneten Löchern einer ersten Führungsplatine (30) axial gleitbar geführt, die einen Durchbruch aufweist, dem eine Vorrichtung (62) zum Inken fehlerhafter Chips zugeordnet ist.

FIG.2

EP 0 233 511 A1

Feinmetall GmbH
7033 Herrenberg


Prüfeinrichtung zur Wafer-Prüfung


Die Erfindung betrifft eine Prüfeinrichtung gemäß dem Oberbegriff des Anspruches 1.

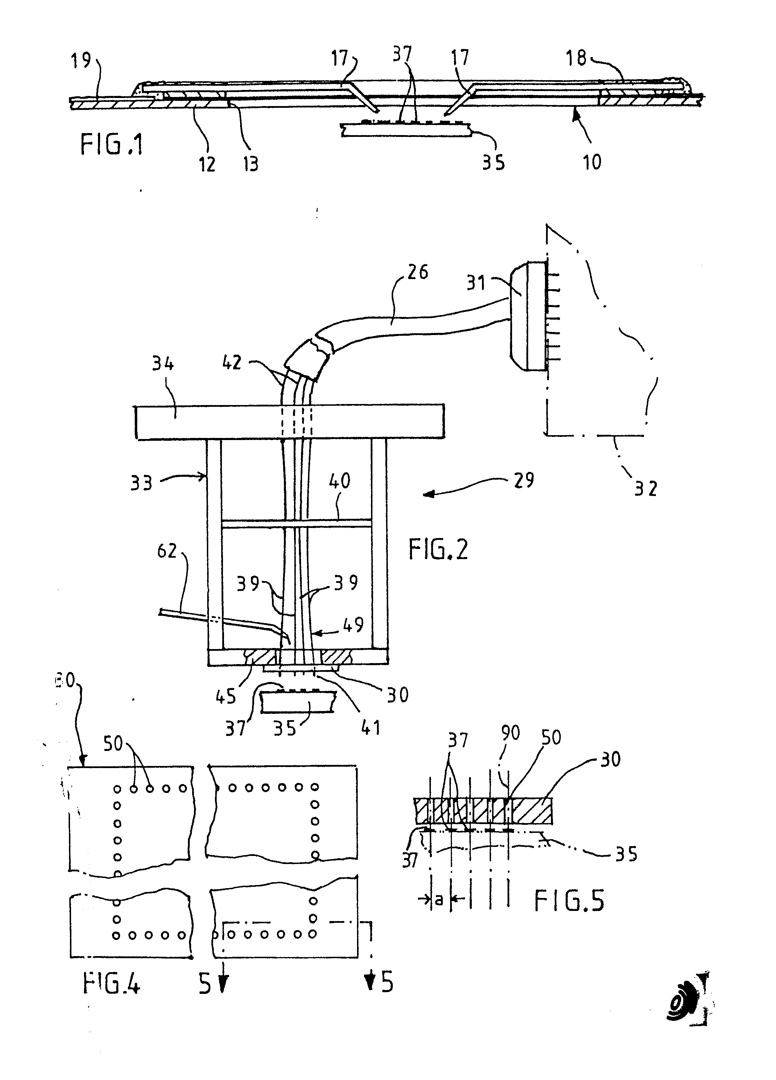

Bisher hat man zur Prüfung der einzelnen Chips auf einem viele unter sich gleiche Chips aufweisenden Wafer, der im allgemeinen eine Siliziumplatte mit den Chips aufweist und nach der Prüfung in die einzelnen Chips zertrennt wird, ausschließlich sogenannte Prüfkarten verwendet, die mit winklig gebogenen Nadeln versehen sind. In Fig. 1 ist ein Teilschnitt durch eine solche Prüfkarte 10 dargestellt. Sie weist eine Leiterplatte 12 mit einer meist runden oder ovalen Öffnung 13 in der Mitte auf, durch die die dem Kontaktieren der Pads 37 jeweils eines Chips eines viele solcher Chips aufweisenden Wafers 35 dienenden Nadeln 17, von denen nur zwei dargestellt sind, hindurchragen. Die Schäfte der Nadeln 17 sind in einem auf die Prüfkarte 10 aufgesetzten Kunststoffring 18 parallel zur Ebene der Leiterplatte 12 gehalten und mit den zugeordneten Leiterbahnen 19 auf der Leiterplatte 12 bspw. durch Lötstellen elektrisch verbunden. Die Nadeln 17 dieser Prüfkarte 10 können jeweils nur die Pads eines einzigen Chips gleichzeitig kontaktieren und sind elektrisch an eine für die Prüfung jeweils eines einzigen Chips ausgebildete Testvorrichtung angeschlossen. Zu diesem Zweck enden die Leiterbahnen 19 in der Regel an einer nicht dargestellten Steckerleiste, die die Verbindung der Prüfkarte 12 mit der Testvorrichtung dieser Prüfeinrichtung, die die elektrische Prüfung durchführt, herstellt. Die Nadeln 17 sind, um alle Pads 37 des jeweiligen Chips gleichzeitig zu kontaktieren, an ihren vorderen Enden um etwa 45° bis 60° nach unten abgebogen. Der Kontaktiervorgang läuft so ab, daß die Prüfkarte 10 auf den Wafer 35 abgesenkt wird, bis die Nadeln 17 sicheren Kontakt mit den Pads 37 eines Chips haben. Die Nadeln federn dabei etwas elastisch aus und ihre Nadelspitzen führen dabei Gleitbewegungen auf den Pads 37 aus, die die Gefahr von Beschädigungen der Pads in sich bergen. Die Kraft, mit der die Nadeln 17 auf die Pads zur Herstellung des elektrischen Kontaktes drücken, ist aus konstruktiven Gründen auf einige cN begrenzt. Diese Nadeln 17 bestehen in den meisten Fällen aus Wolfram, weil sich durch dessen hohen Elastizitätsmodul auch bei geringem Durchmesser des Nadelschaftes die erforderlichen Kontaktkräfte noch erreichen lassen. In Sonderfällen werden auch Nadeln aus CuBe oder Palladium verwendet, und zwar, wenn der Kontaktwiderstand besonders klein bleiben muß. Bekanntlich neigt Wolfram zu Kontamination, so daß sich auf dieser Oberfläche isolierende Schichten bilden können. CuBe und Palladium weisen andererseits eine geringere Härte als Wolfram auf, so daß sich die Nadelspitzen aus diesen Materialien schnell abnutzen.

Bei den modernen hochintegrierten, durch die Chips gebildeten Schaltkreisen ist die Anzahl der Pads pro Chip oft sehr groß. Die Prüfkarte 10 kontaktiert jeweils die Pads eines Chips gleichzeitig. Auf einem Wafer sind sehr viele Chips von normalerweise quadratischer oder rechteckförmiger Gestalt in geringen Abständen nebeneinander angeordnet und die Pads befinden sich nahe den Rändern des Chips an allen vier Seiten des Chips. Es sind schon Prüfkarten mit 256 Nadeln hergestellt worden. Noch höhere Nadelanzahlen waren bisher nicht erreichbar, so daß entsprechend mit Prüfkarten nur Chips mit maximal 256 Pads prüfbar waren. Die Anfertigung derartiger Prüfkarten ist umso komplizierter und teurer, je größer die Anzahl der Nadeln ist, da die Nadelabstände sehr klein sind und die Nadelspitzen mit höchster Präzision entsprechend der Anordnung der Pads des Chips ausgerichtet werden müssen. Infolge des geringen Durchmessers des Nadelschaftes können diese Nadeln bei unsachgemäßer Handhabung leicht verbogen werden, insbesondere bei Prüfkarten mit sehr vielen Nadeln. Aus Platzgründen sind bei solchen Prüfkarten mit sehr vielen Nadeln die frei über die Karte überstehenden Längen der Nadeln besonders groß und sie sind dann besonders empfindlich. Eine Reparatur derartiger Prüfkarten, z.B. durch Auswechseln einzelner Nadeln ist nicht möglich. Die Lebensdauer derartiger Prüfkarten ist somit in der Regel nur kurz.

Es ist deshalb eine Aufgabe der Erfindung, eine Prüfeinrichtung für Wafers zu schaffen, bei welcher die Nadeln sich besser gegen Beschädigungsgefahr schützen lassen.

Diese Aufgabe wird erfindungsgemäß durch eine Prüfeinrichtung gemäß Anspruch 1 gelöst.

Diejenigen Enden der Nadeln, die in Kontakt mit den Pads kommen, seien als freie Kontaktenden bezeichnet. Diese können bevorzugt leicht abgerundet sein, damit sie die empfindlichen Pads besonders gut schonen. Günstig ist auch, daß bei der Erfindung die Nadeln auf den Pads nicht mehr zu gleiten brauchen, so daß die bei Prüfkarten vorhandene Beschädigungsgefahr der Pads behoben ist.

Der Prüfkopf oder die sonstige Tragvorrichtung der Nadelanordnung weist hohe Betriebssicherheit auf und läßt auch lange Lebensdauer erreichen und ermöglicht das Inken von bei der Prüfung als fehlerhaft ermittelten Chips zu deren Kennzeichnung, so daß sie später aussortiert oder, falls erwünscht und möglich, der betreffende Fehler behoben werden kann.

Da die Pads an einem Chip nahe dem äußeren Rand angeordnet sind, kann für das Inken fehlerhafter Chips im Zentrum der betreffenden Nadelanordnung in der ersten Führungsplatine eine Öffnung vorgesehen sein, durch die eine Vorrichtung zum Inken (mit Tinte oder dgl. anspritzen) von als Ausschuß ermittelten Chips hindurch die betreffenden fehlerhaften Chips kennzeichnen kann. Die Anzahl der Nadeln kann ohne Probleme wesentlich größer gemacht werden, als bei Leiterkarten bisher möglich war, so daß nunmehr auch Wafers mit Chips mit größeren Anzahlen von Pads als bisher durch die Nadeln des Prüfkopfes oder dgl. kontaktiert werden können. Dabei läßt sich der Prüfkopf oder dgl. kostengünstig baulich relativ einfach realisieren. Die Erfindung ermöglicht also auch Wafers, deren Chips bisher mit den Leiterkarten nicht geprüft werden konnten.

Auch sind die Nadeln durch die erste Führungsplatine gegen Beschädigungsgefahr ihrer empfindlichen freien Endbereiche, die die freien Kontaktenden aufweisen, sehr gut geschützt, weil ihre Endbereiche nur wenig über die erste Führungsplatine überzustehen brauchen oder bei einer bevorzugten Ausführungsform, bei der die erste Führungsplatine beweglich gelagert ist, sogar sich ständig innerhalb der ersten Führungsplatine befinden können. Die Kontaktnadeln brauchen deshalb auch nicht aus Wolfram zu bestehen, obwohl dies auch möglich ist. Es ist besonders zweckmäßig, die freien Kontaktenden der Nadeln eng benachbart der ersten Führungsplatine vorzusehen, bevorzugt den Abstand der freien Nadelkontaktenden von der ersten Führungsplatine so klein wie nur möglich vorzusehen.

Auch können die Kräfte, mit der die Nadeln auf die Pads drücken, höher als bei den erwähnten Leiterkarten sein, was die Sicherheit der Prüfung entsprechend verbessert.

Auch läßt sich durch die Erfindung ohne Schwierigkeiten Anordnung der freien Kontaktenden der Nadeln kostengünstig mit höchster Präzision erreichen, wie sie bei Leiterkarten nicht, oder wenn überhaupt, nur mit hohem Aufwand erreichbar war. Auch können die Mittenabstände benachbarter Pads besonders klein sein. Die Erfindung ermöglicht es auch, was mit Leiterkarten bisher nicht möglich war, daß der Prüfkopf gleichzeitig nicht nur zur Prüfung eines einzelnen Chips ausgebildet sein muß, was zwar auch möglich ist und bei den erwähnten Leiterkarten bisher unumgänglich der Fall war, sondern auch für die gleichzeitige Kontaktierung von zwei oder noch mehr Chips des Wafers ausgebildet werden kann, indem eine entsprechende Mehrzahl von unter sich gleichen Nadelanordnungen am Prüfkopf nebeneinander angeordnet sind, vorzugsweise zwei bis vier Nadelanordnungen, von denen die einzelne Nadelanordnung dem Kontaktieren der Pads jeweils eines Chips dient. Diese Nadelanordnungen können vorzugsweise dem Kontaktieren benachbarter Chips dienen und vorzugsweise in einer oder zwei Reihen angeordnet sein.

Es können so gleichzeitig die Pads mehrerer Chips durch die Nadelanorndungen kontaktiert werden, und man kann dann zweckmäßig diese Nadelanordnungen zum aufeinanderfolgenden Prüfen der von ihnen kontaktierten Chips aufeinanderfolgend an dieselbe einzige Testvorrichtung der Prüfeinrichtung elektrisch anschließen, so daß weiterhin nur eine Testvorrichtung zum jeweiligen Prüfen eines einzigen Chips erforderlich ist, jedoch die Prüfung der Chips des Wafers dennoch erheblich weniger Zeit als bisher benötigt. Oder, falls es kostenmäßig rentabel ist, können auch mehrere unter sich gleiche Testvorrichtungen vorgesehen sein, so daß jeder Nadelanordnung eine eigene Testvorrichtung zugeordnet ist oder die Nadelanordnungen in zwei oder mehr Gruppen unterteilt sind, denen je eine Testvorrichtung zugeordnet ist, wobei die Nadelanordnungen der einzelnen Gruppe dann wiederum

0233511

bei der Prüfung aufeinanderfolgend an die dieser Gruppe zugeordnete Testvorrichtung elektrisch angeschlossen werden.

Im allgemeinen sind die Chips auf den Wafers quadratisch oder rechteckförmig und die Pads nahe dem Rand des betreffenden Chips entlang aller seiner Seiten in jeweils einer Reihe pro Seite angeordnet. Wenn der Chip also vier gerade Seiten hat, dann sind vier gerade Reihen von Pads entlang seinen vier Seiten angeordnet. Die Pads kann man auch als Kontakt- oder Anschlußflächen bezeichnen. Sie dienen dem elektrischen Anschluß des Chips. Die Mittenabstände benachbarter Pads in der jeweiligen Reihe sind sehr klein. Vorzugsweise kann die erfindungsgemäße Prüfeinrichtung für die Prüfung von Wafers vorgegsehen sein, bei deren Chips der genannte Mittenabstand der Pads in der jeweiligen Reihe max. 0,2 mm beträgt. Die Nadeln können aus elektrisch leitfähigem, elastisch federndem Metall oder Metallegierungen bestehen, z.B. zweckmäßig aus einer aushärtbaren Cu-Legierung, wie CuBe, oder aus einer elastischen Edelmetallegierung, oder aus Stahl, der mit einer Oberflächenbeschichtung vorzugsweise aus Nickel und/oder Edelmetall versehen ist, oder auch aus Wolfram, wenn die Erhöhung des elektrischen Widerstandes durch Kontamination oder andere
Eigenschaften des Wolframs nicht stören. Auch andere
metallische elektrische Leitfähigkeit aufweisende
elastische Materialien kommen in Frage.

Die Oberfläche der Nadeln kann mit Ausnahme der
Stellen, die dem Kontaktieren dienen, mit einem
elektrisch isolierenden Überzug versehen sein, was
meist zweckmäßig ist.

Die Nadeln können irgendeine geeignete Bauart haben.
Vorzugsweise kann die Nadel eine separate Nadel oder
ein Längsabschnitt eines Leitungsdrahtes sein, der an
dem der Nadel entgegengesetzten Ende an einen Stecker
oder dgl. angeschlossen sein kann.

Die Länge der Nadeln kann vorzugsweise etwa das 50-
bis 300-fache, besonders zweckmäßig etwa das 100- bis
200-fache ihres Durchmessers betragen. Bevorzugt
können die in Anspruch 8 angegebenen Bemaßungen
vorgesehen sein.

Die Nadel kann zweckmäßig zylindrisch, vorzugsweise
mit abgerundetem oder angespitztem freien
Kontaktende, oder zum freien Kontaktende und/oder zum
rückwärtigen Ende hin schwach konisch sein, vorzugsweise mit einem von der Längsachse aus gemessenen Konuswinkel von ungefähr 5°. Der vordere konische Bereich der Nadel kann zweckmäßig nur ein Teilabschnitt ihrer Länge sein und bis zu ihrem freien Kontaktende reichen. Vorzugsweise kann dieser konische Bereich sich durch die erste Führungsplatine hindurch erstrecken.

Wenn die einzelne Nadel als separate Nadel ausgebildet ist, kann zweckmäßig vorgesehen sein, daß ihr rückwärtiges Ende an einen elektrischen Gegenkontakt lediglich angedrückt ist, an den ein weiterführender elektrischer Leiter angeschlossen ist, oder sie kann mit einem solchen Leiter auf irgend eine sonstige Weise lösbar oder in manchen Fällen auch nicht lösbar verbunden sein.

Besonders vorteilhaft ist es, wenn die einzelne Nadel oder der sie aufweisende Draht am Prüfkopf so angeordnet ist, daß man die Nadel bzw. den Draht jederzeit auswechseln kann, so daß, wenn eine Nadel beschädigt wird, man sie auswechseln kann. Wie erwähnt, mußten dagegen bei den bekannten Prüfkarten diese stets dann ausgewechselt werden, wenn nur eine einzige ihrer Nadeln für die Prüfung unbrauchbar wurde.

Bei einer bevorzugten Weiterbildung ist vorgesehen, daß der Prüfkopf eine zweite Führungsplatine aufweist, in der die Nadeln ebenfalls in Löchern axial gleitbar geführt sind. Diese zweite Führungsplatine verbessert zum einen den Schutz der Nadeln gegen Beschädigung noch weiter, und zum anderen kann sie auch dazu dienen, die Nadeln schwach zu biegen, um hierdurch das axiale Federn ihrer freien Kontaktenden zu erleichtern, wobei diese Federwirkung durch diese schwache Biegung bewirkt wird. Es kann jedoch auch vorgesehen sein, daß die Nadeln bereits im entspannten Zustand solche Gestalt aufweisen, daß sie axial federn können, also bereits im entspannten Zustand schwach gebogen sind oder in manchen Fällen auch stärkere Biegungen, bspw. eine wellenförmige Biegung oder eine U-förmige Biegung aufweisen können. Die Tiefe der Wölbung der Nadel kann sehr gering sein, vorzugsweise einige zehntel Millimeter betragen.

Auch wenn keine zweite Führungsplatine vorhanden ist, kann man die rückwärtigen Enden der Nadeln an einer sie haltenden Halteplatte anordnen, vorzugsweise derart, daß die Nadeln hierdurch schwach gebogen werden zwecks leichter axialer Federung der freien Kontaktenden. Auch wenn mindestens eine zweite Führungsplatine vorhanden ist, kann eine solche Halteplatte mit vorgesehen sein und die zweite Führungsplatine verbessert den Schutz der empfindlichen Nadeln und kann auch zur der axialen Federung der freien Kontaktenden dienenden Biegung der Nadel beitragen oder sie allein oder im wesentlichen allein bewirken.

Durch die Erfindung lassen sich die Nadeln viel besser als bei den Prüfkarten gegen Beschädigung schützen, insbesondere durch die erste Führungsplatine. Zu diesem Zweck ist die erste Führungsplatine benachbart den freien Kontaktenden der Nadeln angeordnet, vorzugsweise nahe oder sehr nahe bei ihnen oder sie nimmt die freien Kontaktenden sogar in sich auf.

Wenn die freien Kontaktenden sich in den Stellungen befinden, in denen auf sie keine axialen Kräfte ausgeübt werden, kann ihr Abstand von der ersten Führungsplatine vorzugsweise maximal 5 Millimeter, besonders vorteilhaft maximal 2 Millimeter betragen. Noch günstiger für Schutz gegen Beschädigungsgefahr ist es, wenn dieser Abstand maximal 1 Millimeter, vorzugsweise maximal 0,6 Millimeter oder noch weniger

0233511

- 14 -

beträgt. Die Nadeln können in den sie aufnehmenden Löchern der ersten Führungsplatine axial gleiten. Bevorzugt kann die Nadel durch ihre Gestalt eigenfedernd in Art einer Biegefeder sein. Zu diesem Zweck kann sie irgendeine Gestalt aufweisen, die es ermöglicht, daß ihr freies Kontaktende durch gegen die von der Nadel selbst ausgeübte Federkraft axial bewegt werden kann. Vorzugsweise weist sie zu diesem Zweck nur schwache Biegung auf ihrem rückseitig der ersten Führungsplatine befindlichen Bereich auf, was durch eine zweite Führungsplatine besonders zweckmäßig bewirkt werden kann, indem sie die in völlig entspanntem Zustand vorzugsweise geraden Nadeln etwas aus ihren geraden Stellungen ausbiegt. Ein Vorteil ist auch, daß der Überstand der freien Kontaktenden der Nadeln über die erste Führungsplatine während des Kontaktierens der Pads durch die Pads noch weiter verringert wird. Es kann vorgesehen sein, daß dieser Überstand dabei praktisch zu Null wird oder nur noch ein bis zwei zehntel Millimeter oder noch weniger beträgt.

Durch die erste Führungsplatine läßt sich auch verhindern, daß die sehr dünnen Nadeln seitlich ausweichen und von den Pads abweichen können, und die empfindlichen freien Kontaktenden dieser Nadeln werden vor Beschädigung und Verschmutzung besonders gut geschützt. Auch wird gute Planarität der geometrischen Ebene gewährleistet, die die freien Kontaktenden der Nadeln definieren. Auch läßt sich ohne weiteres erreichen, daß die von den Nadeln auf die Pads gleichzeitig ausgeübten Kontaktkräfte unter sich etwa gleich groß sind, was bei den Nadeln von Prüfkarten nicht oder nur sehr schwierig erreichbar war.

Die erste Führungsplatine kann am Prüfkopf oder dgl. unbeweglich angeordnet sein und die Nadeln müssen dann zumindest so weit über die Führungsplatine in Richtung auf die zu kontaktierenden Pads überstehen, daß letztere die freien Kontaktnadelenden so weit in Richtung auf die erste Führungsplatine zu verschieben können, daß die dann vorliegenden Kontaktkräfte der Nadeln ausreichend groß sind. Es ist zweckmäßig, diesen Überstand der freien Kontaktenden nur so groß wie unbedingt nötig vorzusehen. Bei einer anderen Ausführungsform der Erfindung ist die erste Führungsplatine in Richtung der in ihr geführten Bereiche der Nadeln beweglich geradegeführt und in Richtung auf die zu prüfenden Wafers zu belastet, vorzugsweise durch mechanische Rückstellfedermittel oder auch durch andere nachgiebige Rückstellmittel, bspw. durch Gasfedern. Es ist dann möglich, die freien Kontaktenden der Nadeln besonders wenig oder überhaupt nicht mehr über die erste Führungsplatine in Richtung auf die Wafers vorstehen zu lassen. Wenn die freien Kontaktenden der Nadeln in der ersten Führungsplatine ganz versenkt sind, sind sie optimal gegen Beschädigungsgefahr geschützt. Dabei kann zweckmäßig vorgesehen sein, daß die Kontaktenden gerade bis zu der geometrischen Ebene reichen, die durch die den Wafers zugewendete Seite der ersten Führungsplatine definiert ist. Bei jedem Prüfvorgang bewegen sich dann praktisch die in der ersten Führungsplatine befindlichen Bereiche der Nadeln mit dieser mit, bleiben also ungefähr in Ruhe, und hierdurch wird der Verschleiß der Nadeln und der ersten Führungsplatine zu Null oder stark reduziert und die Lebensdauer weiter erhöht.

Die Führungsplatine kann aus elektrisch isolierendem Material bestehen, z.B. Kunststoff, Keramik, Glas, Glaskeramik oder auch aus Metall mit isolierendem Überzug. Dieser Überzug kann Kunststoff sein. Er kann auch Oxid sein, z.B. Aluminium-Oxid auf Aluminium.

Zur Herstellung der Löcher in der ersten bzw. zweiten Führungsplatine für die Nadeln kann jede bekannte Technik verwendet werden, die sich für das betreffende Material eignet, wie Bohren, Stanzen, Laserbohren, Ätzen, elektrolytisches Abtragen usw..

Die erste und/oder die oder jede zweite Führungsplatine kann in vielen Fällen zweckmäßig jeweils aus einer einzelnen Platte bestehen oder aus mehreren Scheiben zusammengesetzt sein. Sie kann sehr klein und vorzugsweise eben sein.

Besonders vorteilhaft ist es für die Führung der Nadeln in der ersten und/oder zweiten Führungsplatine und für deren kostengünstige Herstellung, wenn die erste bzw. zweite Führungsplatine für die Nadeln Ausnehmungen aufweist, die jeweils einen kurzen lochförmigen Abschnitt zur axialen Führung der betreffenden Nadel und einen außer Kontakt mit der betreffenden Nadel befindlichen längeren Abschnitt, welcher ebenfalls lochförmig oder ein zum benachbarten Rand der Führungsplatine hin offener Schlitz ist, aufweist. Dies kann bei einstückiger Führungsplatine durch entsprechendes Bohren erreicht werden, besonders zweckmäßig dadurch, daß die Führungsplatine aus zwei Scheiben besteht, von denen die eine Scheibe als Positionierscheibe dient und die lochförmigen kürzeren Durchbrüche aufweist und die andere Scheibe eine die Positionierscheibe gegen Wölben sichernde starre Stützplatte ist. Die Positionierscheibe kann vorzugsweise eine Kunststoff-Folie sein, in die die der Positionierung der Nadeln dienenden Löcher eingestanzt sein können, was ein besonders genaues und wirtschaftliches Herstellungsverfahren ist. Die Positionierscheibe kann jedoch auch andere Ausbildung aufweisen. Sie läßt sich aus Material herstellen, das besonders geringen Gleitreibungskoeffizienten mit den Nadeln hat, wie bspw. zweckmäßig Polytetrafluoräthylen.

In den Fig. 2-9 sind Ausführungsbeispiele der Erfindung dargestellt. Es zeigen:

Fig. 2    eine Seitenansicht eines Prüfkopfes gemäß einem ersten Ausführungsbeispiel der Erfindung einer nicht in weiteren Einzelheiten dargestellten Prüfeinrichtung zum Prüfen von Wafers in im wesentlichen schematischer Darstellung, wobei von den insgesamt vorhandenen Nadeln nur einige dargestellt sind,

Fig. 3    eine Seitenansicht eines Prüfkopfes gemäß einem zweiten Ausführungsbeispiel der Erfindung,

Fig. 4,   jeweils eine gebrochene, ausschnittsweise
6 und 8   Draufsicht auf eine Führungsplatine,

Fig. 5,   Teilschnitte durch die Führungsplatinen
7 und 9   nach den Fig. 4,6 und 8, gesehen entlang den Schnittlinien 5-5 bzw. 7-7 bzw. 9-9,

Fig. 10   eine Draufsicht auf eine vollständige erste Führungsplatine.

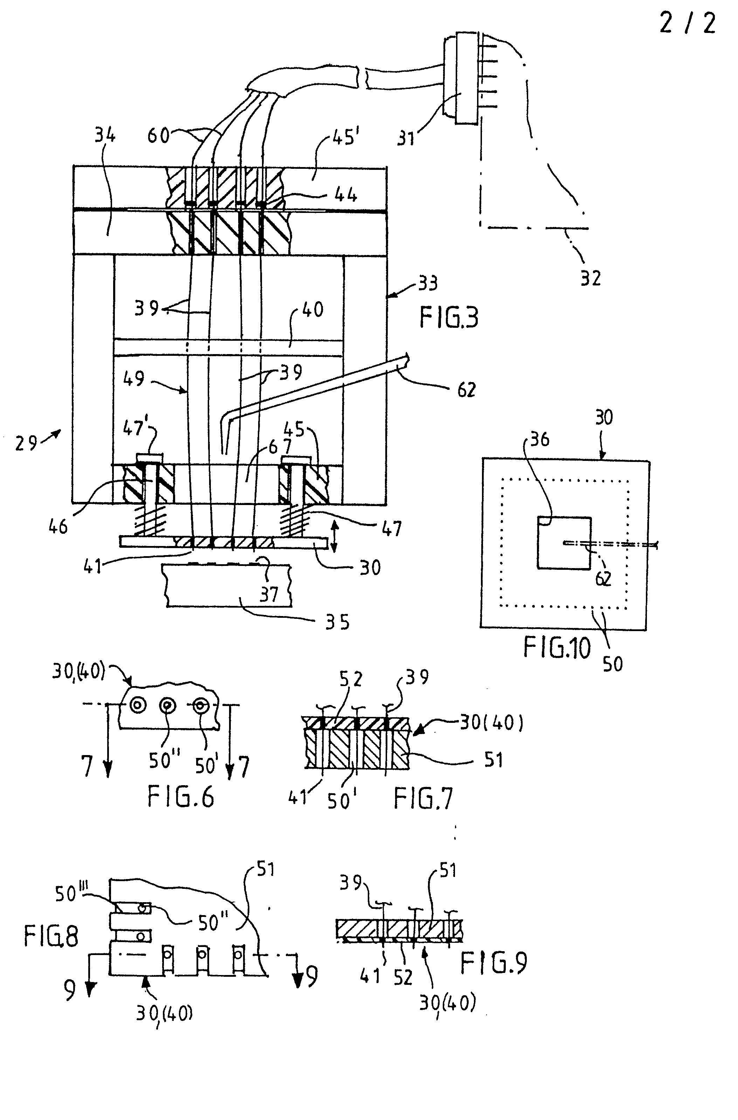

In den Fig. 2und 3 ist je ein jeweils eine Kontaktiervorrichtung zum Kontaktieren von Chips auf Wafers 35 bildender Prüfkopf 29 einer Prüfeinrichtung zum Prüfen von jeweils eine Vielzahl von Chips aufweisenden Wafers 35 dargestellt, die dem Wafer 35 der Fig. 1 entsprechen können. Die jeweilige Prüfeinrichtung weist außer dem Prüfkopf 29 noch eine Testvorrichtung 32 auf, an die der Prüfkopf 29 mittels eines Kabels 26 und des am Kabel 26 angeordneten Steckers 31 angeschlossen werden kann. Die Testvorrichtung 32 kann die Chips des jeweiligen Wafers 35 einzeln nacheinander prüfen. Bei jeder solchen Prüfung eines Chips sind dessen Pads 37 zur Herstellung der elektrischen Verbindungen zur Testvorrichtung 32 durch Nadeln 39 des betreffenden Prüfkopfes 29 gleichzeitig kontaktiert. Diese Testvorrichtung 32 kann bspw. ein Gerät bilden. Der Wafer 35 kann ein Silizium-Wafer oder ein sonstiger, Chips aufweisender Wafer sein.

Bei den in den Figuren 4 bis 9 dargestellten Führungsplatinen kann es sich sowohl um erste Führungsplatinen 30 als auch um zweite Führungsplatinen 40 der in den Fig. 2 und 3 dargestellten Prüfköpfe 29 handeln.

Der in Fig. 2 dargestellte Prüfkopf 29 weist einen
starren Rahmen 33 auf, auf dem obenseitig eine ebene,
horizontale Halteplatte 34 befestigt ist, die bspw.
an einem Vertikalschlitten der Prüfeinrichtung fest
angeordnet sein kann, mittels welchem dieser Prüfkopf
29 zum Prüfen der Chips von Wafers, wie dem
ausschnittsweise angedeuteten Wafer 35, auf- und
abbewegt werden kann. Dieser Prüfkopf prüft alle
Chips des jeweils unter ihn gebrachten Wafers 35
aufeinanderfolgend durch und fehlerhafte Chips werden
durch Inken mittels einer Kanüle 62 gekennzeichnet.
Nach erfolgtem Prüfen wird der scheibenförmige Wafer
in die einzelnen Chips zerschnitten.

Im Boden 45 des Rahmens 33 ist ein Durchbruch 67
vorhanden, der untenseitig durch eine ebene, starre,
dünne, plattenförmige erste Führungsplatine 30
überdeckt ist. Im Abstand von vorzugsweise etwa 0,5
bis 1,5 cm ist oberhalb dieser ersten Führungsplatine
30 im Rahmen eine zweite ebene, starre, dünne,
plattenförmige Führungsplatine 40 unbeweglich
angeordnet.

In der horizontalen ersten Führungsplatine 30 sind
Durchgangslöcher für vertikal angeordnete Nadeln 39 exakt gemäß der Anordnung der Mitten der Pads 37 eines Chips von durch diesen Prüfkopf 29 mittels der Nadeln 39 zu kontaktierenden Chips von Wafers, wie 35, angeordnet. Ein Wafer weist im allgemeinen eine sehr große Anzahl solcher Chips in Reihen und Spalten auf, die unter sich gleich ausgebildet sind und integrierte Schaltkreise oder Schaltungen bilden. Meist weist der Chip rechteckförmigen oder quadratischen Umriß auf und die Pads sind entlang seinen vier Seiten in geringen Abständen voneinander in jeweils einer Reihe angeordnet. Die Zahl der Nadeln 39 des Prüfkopfes 29 und die Anordnung der von ihnen durchdrungenen Löcher der ersten Führungsplatine 30 entspricht der Anzahl der gleichzeitig zu kontaktierenden Pads 37 eines Chips 35, bei denen es sich normalerweise um sämtliche Pads des Chips 35 handeln kann und der Anordnung der Zentren der Pads. Die Chips eines Wafers sind unter sich gleich.

Die Nadeln 39 sind in den von Ihnen durchdrungenen Löchern der ersten Führungsplatine 30 und darunter bis zu ihren freien Kontaktenden genau parallel zueinander und senkrecht zur Ebene des Wafers 35 und darüber auch parallel oder ungefähr parallel zueinander und ungefähr senkrecht zur Ebene des Wafers 35 gerichtet. Sie sind in den Löchern der ersten und der zweiten Führungsplatine 30,40 mit geringem Gleitlagerspiel in vertikaler Richtung axial gleitbar gelagert. Die Nadeln sind mit Ausnahme ihrer dem Kontaktieren von Pads 37 dienenden freien Kontaktenden 41 elektrisch isoliert und bilden in diesem Ausführungsbeispiel im wesentlichen gerade vertikal angeordnete Längsabschnitte elastischer Drähte 42, deren rückwärtige Enden an den elektrischen Stecker 31 angeschlossen sind. Die Drähte können bspw. 10 bis 20 cm lang sein, wogegen ihre vertikal angeordneten Längsbereiche, die die Nadeln bilden, relativ kurz sind, vorzugsweise ungefähr 0,5 bis 3 cm, besonders zweckmäßig etwa 1 bis 2 cm lang sein können. Und zwar reicht der eine einzelne Nadel 39 bildende Bereich des betreffenden Drahtes 42 von der oberen Oberseite der Halteplatte 34 bis zum freien Kontaktende 41. Jede Nadel durchdringt in der Halteplatte 34 ein nur ihr zugeordnetes Loch, so daß diese Lochanordnung in der Halteplatte 34 für die Nadeln ungefähr der Lochanordnung in der ersten Führungsplatine 30 zweckmäßig entsprechen kann. An der Halteplatte können die Drähte 42 bspw. dadurch gehalten sein, indem man sie an der Oberseite und der Unterseite der Halteplatte 34 etwas zusammendrückt, so daß sie hier verbreitert sind, oder man kann auch andere Mittel vorsehen, bspw. sie an die Halteplatte 34 anzukleben. Es ist zweckmäßig, diese Drähte 42 mit Ausnahme der freien Kontaktenden 41 elektrisch zu isolieren, so daß sie oberhalb der Halteplatte 34 zu einem Kabel zusammengefaßt werden können.

Die erste Führungsplatine 30 kann sehr klein sein, da sie nicht oder nicht viel größer als ein Chip zu sein braucht.

Die von den Nadeln 39 durchdrungenen Löcher der zweiten Führungsplatine 40 können exakt dieselbe geometrische Anordnung wie die entsprechenden Löcher der ersten Führungsplatine 30 aufweisen. Um in diesem Falle die Nadeln im Bereich zwischen der ersten Führungsplatine 30 und der Halteplatte 34 zwecks axialer Federung ihrer freien Kontaktenden schwach zu biegen, kann diese Lochanordnung der zweiten Führungsplatine 40 relativ zu der Lochanordnung der ersten Führungsplatine 30 horizontal etwas versetzt sein. Zu demselben Zweck des schwachen Biegens der Nadeln 39 kann auch vorgesehen sein, daß die Lochanordnung für die Nadeln der zweiten Führungsplatine 40 relativ zur Lochanordnung der ersten Führungsplatine 30 etwas größer oder kleiner vorgesehen ist. Und zwar ist im Ausführungsbeispiel nach Fig. 2 der Fall dargestellt, daß die Lochanordnung der zweiten Führungsplatine 40 kleiner und im Ausführungsbeispiel nach Fig. 3 größer als die Lochanordnung der ersten Führungsplatine 30 ist. Die Lochanordnung in der ersten Führungsplatine 30 ist so vorgesehen, daß die Längsachsen ihrer Löcher auf die Zentren der Pads 37 eines von den Nadeln 39 kontaktierten Chips 35 gerichtet sind. Die Löcher für die Nadeln verlaufen in der ersten Führungsplatine ungefähr oder genau parallel zueinander. Auch die Löcher für die Nadeln 39 in der zweiten Führungsplatine 40 können ungefähr oder genau parallel zueinander sein, desgleichen die Löcher in der Halteplatte 34.

Die Nadeln 39 sind gleich lang und haben konstanten Überstand über die erste Führungsplatine 30 nach unten, so daß ihre freien Kontaktenden eine gemeinsame, zum Wafer 35 parallele geometrische Ebene definieren, zu der die Längsachsen der die Nadeln 39 in der ersten Führungsplatine 30 axial gleitbar führenden Löcher senkrecht gerichtet sind.

Die Nadeln 39 stehen über die erste Führungsplatine 30 nach unten nur wenig vor, vorzugsweise nur einige zehntel Millimeter und die Eigenelastizität dieser
Nadeln 39 ist so getroffen, daß beim axialen
Verschieben ihrer freien Kontaktenden 41 durch die
von ihnen kontaktierten Pads 37 auf einer Strecke,
die gleich oder etwas kleiner als der genannte
Überstand der Nadeln über die erste Führungsplatine
ist, bereits die für die Prüfung vorgesehenen
Kontaktkräfte, die bevorzugt erheblich größer als bei
den vorbekannten Prüfkarten sein können, durch ihre
Eigenelastizität bewirkt werden, so daß der Überstand
der freien Kontaktenden 41 der Nadeln 39 über die
erste Führungsplatine 30 dem bei der Prüfung
auftretenden Federungsweg oder Hub der freien
Kontaktenden 41 im wesentlichen entspricht oder
gleich groß wie dieser Federungsweg ist. Die Nadeln
39 können wegen der beschriebenen Eigenfederung
unbeweglich in der Halteplatte 34 gehalten sein. In
diesem Ausführungsbeispiel sind die Nadeln
einstückige Abschnitte der Drähte 42. Die Nadeln
reichen von ihren freien Kontaktenden 41 bis zur
oberen Stirnseite der Halteplatte 34 und sind im
wesentlichen gerade, da sie zwischen der ersten
Führungsplatine 30 und der Halteplatte 34 nur
geringfügig gebogen sind. Wie dargestellt, sind die
erste Führungsplatine 30 und die zweite
Führungsplatine 40 jeweils dünne Platten, deren Dicke viel kleiner als die Länge der Nadeln 39 ist. Die freien Kontaktenden 41 dieser Nadeln 39 können durch seitliches, zumindest im wesentlichen außerhalb der Führungsplatinen 30, 40 erfolgendes Ausbiegen der Nadeln 39 axial federn. Dies ist besonders zweckmäßig.

Zweckmäßig können die Nadeln runde Querschnitte aufweisen und zylindrisch sein. Oder sie können ggf. auf ihre freien Kontaktenden 41 zu bis zu ihnen sich schwach konisch verjüngen, vorzugsweise jedoch nur auf kurzen Endbereichen, die vorzugsweise kurz oberhalb der ersten Führungsplatine beginnen und wie erwähnt bis zu den freien Kontaktenden 41 reichen können, wodurch das Gleiten der Nadeln in den Löchern der ersten Führungsplatine 30 erleichtert und auch die Präzision des Kontaktierens der Pads durch die freien Kontaktenden erhöht wird, da sie, wenn sie auf die Pads auftreffen, in den Löchern der ersten Führungsplatine dann kein Seitenspiel mehr zu haben brauchen, oder nur sehr geringes Seitenspiel.

Dieses Seitenspiel vergrößert sich dann zur leichten Beweglichkeit der Nadeln in der ersten Führungsplatine, wenn die freien Kontaktenden der Nadeln durch die Pads axial nach oben gedrückt werden. Dann ist jedoch bereits die Stellung der freien Kontaktenden auf den Pads durch die Kontaktkräfte fixiert.

Zum Kontaktieren der Pads eines Chips ist es lediglich erforderlich, den Prüfkopf und/oder den betreffenden Wafer in zur ersten Führungsplatine paralleler Anordnung bis zum Inkontaktkommen der freien Kontaktenden mit den Pads vertikal zu bewegen und dann wird diese Bewegung noch so lange fortgesetzt, bis die Pads nur noch sehr geringen Abstand von vorzugsweise nur einigen hundertstel Millimetern oder gar keinen Abstand mehr von der ersten Führungsplatine 30 haben. Die Halteplatte 34 und die beiden Führungsplatinen 30, 40 sind parallel zueinander angeordnet.

In der ersten Führungsplatine 30 ist innerhalb der Nadelanordnung 49 eine Durchbrechung 36 (Fig. 10) vorgesehen, durch die hindurch eine Kanüle 62 bei der Prüfung als fehlerhaft befundene Chips inken, d.h. mit Tinte oder dgl. zu ihrer Kenntlichmachung anspritzen kann.

Dieser Prüfkopf 29 ist äußerst betriebssicher, hat hohe Lebensdauer und der Verschleiß seiner Nadeln 39 ist minimal. Die Beschädigungsgefahr der Nadeln 39 ist außerordentlich gering. Falls dennoch einmal eine Nadel aus irgendwelchen Gründen ausgewechselt werden muß, ist es nur notwendig, den betreffenden Draht 42 gegen einen anderen Draht auszuwechseln. Auch können die Nadeln ohne weiteres so ausgebildet sein, daß sie besonders hohe Kontaktkräfte ausüben können. Die zylindrischen Bereiche der Nadeln 39 können vorzugsweise Durchmesser von 0,03 bis 0,3 mm, besonders günstig von ca. 0,05 bis 0,15 mm, aber je nach Wafer auch noch kleiner oder größer sein.

Die Dicke der ersten Führungsplatine 30 und/oder der zweiten Führungsplatine 40 kann bspw. zweckmäßig 0,5 bis 4 mm betragen. Da sie sehr klein ist, ergeben solche Dicken schon ausreichende Festigkeit.

Der Prüfkopf 29 nach Fig. 3 unterscheidet sich von dem nach Fig. 2 im wesentlichen in folgenden Einzelheiten. Die Nadeln 39 sind hier separate, einstückige Nadeln, die von ihren freien Kontaktenden 41 bis etwas über die Halteplatte 34 nach oben hinaus reichen, und ihre oberen, rückwärtigen Enden sind an Kontakte 44 angedrückt, die in einer Kontaktträgerplatte 45' gegeneinander elektrisch isoliert angeordnet sind. An diese Kontakte 44 sind Anschlußdrähte 60 angeschlossen, die ihrerseits an den Stecker 31 angeschlossen sind.

Jede Nadel 39 ist wiederum im wesentlichen gerade und durchdringt je ein zugeordnetes Loch in der Halteplatte 34. In diesem Loch kann sie bspw. wie bei Fig. 2 beschrieben, gehalten sein, so daß sie leicht ausgewechselt werden kann. Die zweite Führungsplatine 40 weist in diesem Ausführungsbeispiel eine Lochanordnung für die Nadeln 39 auf, die etwas größer als die entsprechende Lochanordnung in der ersten Führungsplatine 30 ist, so daß die Nadeln zwischen der ersten Führungsplatine 30 und der Halteplatte 34 schwach nach außen gebogen sind und hierdurch ihre axiale Eigenelastizität erhalten, die das axiale Federn ihrer freien Kontaktenden 41 ermöglicht. In den Löchern der ersten und der zweiten Führungsplatine 30 bzw. 40 können diese Nadeln 39 mit geringem Gleitlagerspiel axial gleiten. Die Lochanordnung für die Nadeln 39 in der Halteplatte 34 kann der der ersten Führungsplatine 30 ungefähr entsprechen.

Die Nadeln 39 können vorzugsweise vor dem Einsetzen in den Prüfkopf 29 völlig gerade gewesen sein und ihre geringe Biegung, die der axialen Eigenfederung dient, durch die zweite Führungsplatine 40 erhalten haben.

In diesem Ausführungsbeispiel ist die erste Führungsplatine 30 in vertikaler Richtung d.h. senkrecht zur Ebene des jeweils zu prüfenden Wafers 35 vertikal gleitbar geradegeführt, indem sie an im Boden 45 des Rahmens 33 vertikal geradegeführten Bolzen 46 untenseitig befestigt ist. Auf diesem Bolzen 46 angeordnete, vorgespannte Druckfedern 47 drücken die erste Führungsplatine 30 in die dargestellte untere Grenzstellung, in der verbreiterte Köpfe 47' der Bolzen auf dem Boden 45 aufliegen.

Die erste Führungsplatine 30 ist in diesem Ausführungsbeispiel also am Prüfkopf 29 in Längsrichtung der in ihrem Bereich befindlichen Abschnitte der Nadeln 39 geradegeführt federnd beweglich angeordnet.

Die Nadeln 39 stehen über die von ihnen durchdrungene erste Führungsplatine 30 nur äußerst wenig nach unten über, vorzugsweise nur wenige Zehntel Millimeter oder wenige hundertstel Millimeter, oder es kann sogar vorgesehen sein, daß sie über diese erste Führungsplatine nach unten überhaupt nicht vorstehen, sondern vorzugsweise nur bis zu den unteren Enden der sie aufnehmenden Löcher dieser ersten Führungsplatine 30 reichen.

In beiden Ausführungsbeispielen nach den Fig. 2 und 3 sind jeweils nur vier Nadeln 39 dargestellt. In Wirklichkeit ist die Anzahl der Nadeln 39 größer, meist sogar sehr viel größer. Es können bspw. zwanzig bis fünfhundert Nadeln oder auch noch mehr oder auch ggf. noch weniger Nadeln vorgesehen sein. Die Anzahl der Nadeln entspricht der Anzahl der durch die Nadelanordnung gleichzeitig zu kontaktierenden Pads 37 des jeweils zu kontaktierenden Chips. Diese Chips haben meist quadratische oder rechteckförmige Gestalt und entlang aller vier Seiten ist je eine Reihe von Pads angeordnet und die Mittenabstände a (Fig. 5) benachbarter Pads 37, d.h. die Abstände der Mittelpunkte benachbarter Pads 37, in der jeweiligen Reihe sind sehr klein, bspw. ca. 0,14 mm. Schon deshalb müssen die Durchmesser der Nadeln 39 sehr klein sein. Bei einem Lochdurchmesser von 0,14 mm kann ihr Durchmesser bspw. 0,07 mm betragen.

Wenn die Pads 37 eines Chips eines Wafers 35 durch die Nadeln 39 dieses Prüfkopfes 29 kontaktiert werden sollen, wird dieser Prüfkopf 29 bzw. der betreffende Wafer 35 in zur ersten Führungsplatine 30 paralleler Lage vertikal bewegt, bis die freien Kontaktenden 41 der Nadeln 39 die Pads 37 kontaktieren und die Bewegung wird fortgesetzt, bis die Nadeln unter elastischem weiteren Biegen ihrer zwischen der ersten Führungsplatine 30 und der Halteplatte 34 befindlichen Bereiche genügend große Kontaktkräfte auf die Pads 37 zur Herstellung sicherer elektrischer Verbindungen mit ihnen ausüben. Diese genügend großen Kontaktkräfte treten jedoch bei dem Ausführungsbeispiel nach Fig. 3 erst dann auf, wenn die erste Führungsplatine 30 durch den Wafer 35 bereits etwas nach oben gedrückt ist, vorzugsweise einige zehntel Millimeter. Bei diesem Ausführungsbeispiel der Erfindung ist es also möglich, die Nadeln 39 nur minimal oder überhaupt nicht über die erste Führungsplatine 30 nach unten überstehen zu lassen, wodurch die hochempfindlichen Nadeln besonders gut geschützt werden und auch der Verschleiß der Nadeln in der ersten Führungsplatine und deren Verschleiß durch diese Nadeln 39 ist praktisch Null oder jedenfalls äußerst gering. Anstatt die erste Führungsplatine 30 durch den Wafer 35 zu bewegen, kann auch vorgesehen sein, sie durch einen Antrieb zu bewegen oder ihr Bewegen zu unterstützen, vorzugsweise derart, daß bei der Prüfung ein vorbestimmter, sehr geringer Abstand von vorzugsweise weniger als 1/10 mm zwischen dem Wafer und der ersten Führungsplatine nicht unterschritten wird. Bspw. kann ein vorbestimmter Mindestabstand geregelt werden.

In diesen Ausführungsbeispielen sind die Nadeln 39 in entspanntem Zustand gerade und durch die zweite Führungsplatine 40 schwach gebogen, also im wesentlichen gerade. Es ist jedoch auch möglich, diese Nadeln in entspanntem Zustand nicht gerade auszubilden, so daß sie durch ihre Gestalt axiale Eigenfederung als Biegefeder erhalten, sie bspw. zwischen der Halteplatte 34 und der ersten Führungsplatine 30 in einem Bogen schwach zu krümmen.

Die in den Fig. 4 und 5 dargestellte Führungsplatine kann die erste Führungsplatine 30 des Prüfkopfes nach Fig. 2 bzw. 3 sein. Sie weist pro Nadel ein zylindrisches Loch 50 auf, dessen Längsachse 90 senkrecht zur Ebene der Führungsplatine 30 verläuft. Ein Wafer 35 ist ausschnittsweise strichzweipunktiert angedeutet. Die Mittelpunkte oder Mitten der bei 37 angedeuteten Pads einer auschnittsweise eingezeichneten Padreihe eines Chips fallen in die zueinander parallelen auf der Ebene des Wafers senkrecht stehenden Längsachsen 90 der Löcher 50, so daß die benachbarten Längsachsen 90 und damit die Mitten der in der Padreihe benachbarten Pads 37 die konstanten Abstände a haben, die vorzugsweise max. 0,15 mm oder in manchen Fällen auch größer sein können. Die zweite Führungsplatine 40 kann ggf. dieselbe Ausbildung wie die erste Führungsplatine 30 aufweisen.

Die Führungsplatine nach den Fig. 6 und 7 kann ebenfalls eine erste Führungsplatine 30 oder eine zweite Führungsplatine 40 bilden. Diese eine dünne Platte bildende Führungsplatine besteht aus zwei Scheiben 51,52, von denen die untere eine dickere Stützplatte 51 ist und die andere eine dünnere, vorzugsweise nur folienartige Positionierscheibe 52, die auf der dickeren Stützplatte 51 flach aufliegt oder an ihr befestigt ist, bspw. mittels Haftkleber angeklebt ist. Die Stützplatte 51 verhindert, daß die dünnere Positionierscheibe 52 sich durchbiegen kann. Die Stützplatte 51 weist für jede Nadel 39 ein Loch 50' solch großen Durchmessers auf, daß die Nadel diese Stützplatte nicht kontaktieren kann. Diese Löcher 50' sind deshalb trotz der Starrheit der Stützplatte 51 kostengünstig herzustellen, bspw. zu bohren. In die viel dünnere, als Positionierscheibe 52 dienende Folie aus Kunststoff oder dgl. sind Löcher 50" wesentlich kleineren Durchmessers eingestanzt und jedes Loch 50" ist koaxial zu dem unter ihm befindlichen Loch 50' der Stützplatte 51. Diese Löcher 50" führen so infolge ihrer Kürze die Nadeln besonders schonend. Auch kann diese Positionierscheibe 52 aus einem Material mit besonders geringem Gleitreibungskoeffizienten zu den Nadeln ausgeführt werden, bspw. aus Polytetrafluoräthylen. Hierdurch werden die Nadeln besonders geschont und auch der Verschleiß dieser Positionierscheibe herabgesetzt.

Anstatt die Ausnehmungen der Stützplatte 51 für die Nadeln 39 als Löcher, hier zylindrische Bohungen, auszubilden, kann auch vorgesehen sein, sie als von der Seite der Stützplatte 51 aus in sie eindringende, bspw. eingesägte oder eingeschliffene Schlitze 50''' auszubilden, wie es in den Fig. 8 und 9 an einem Ausführungsbeispiel dargestellt ist.

Anstatt einer einzigen zweiten Führungsplatine 40 können ggf. auch mehrere solche zweiten Führungsplatinen in Abständen übereinander angeordnet sein, wenn dies für noch stärkeren Schutz der Nadeln 39 erwünscht ist.

In vielen Fällen, besonders wenn die Nadeln nicht sehr dünn sind, ist es auch möglich, die zweite Führungsplatine 40 wegzulassen und sie dann von der ersten Führungsplatine 30 aus direkt zur Halteplatte 34 zu führen.

Anstatt im Ausführungsbeispiel nach den Fig. 6 und 7 die Positionierscheibe 52 auf der Oberseite der Stützplatte 51 anzuordnen, kann sie besonders zweckmäßig auch an ihrer Unterseite, also benachbart den freien Kontaktenden 41 der Nadeln 39 angeordnet sein, da hierdurch die Kontaktnadeln bis zu den Pads oder bis sehr nahe zu ihnen geführt werden, wie es in Fig. 9 dargestellt ist.

In der ersten Führungsplatine 30 des Prüfkopfes 29 nach Fig. 3 befindet sich innerhalb der Nadelanordnung 49 ebenfalls eine größere Durchbrechung, wie es bspw. Fig. 10 bei 36 zeigt, durch die hindurch eine Kanüle 62 bei der Prüfung als fehlerhaft befundene Chips ebenfalls inken kann.

Die Kanüle 62 ragt in diesem Ausführungsbeispiel zwischen zwei benachbarten Nadeln 39 hindurch in den

0233511

Innenraum der durch die Nadeln 39 gebildeten Nadelanordnung 49 zwischen der ersten und der zweiten Führungsplatine 30,40 wie dargestellt hinein. Doch kann ggf. auch vorgesehen sein, daß die Kanüle 62 von außerhalb der Nadelanordnung 49 aus zwischen zwei benachbarten Nadeln 39 hindurch die dem Inken dienende Flüssigkeit auf den jeweiligen, als fehlerhaft befundenen Chip durch die Durchbrechung, wie 36 (Fig. 10), der ersten Führungsplatine 30 hindurch in entsprechend dünnem Strahl spritzen kann. Oder die Kanüle 62 kann bspw. von oben durch die Kontaktträgerplatte 45' und die Halteplatte 34 (Fig. 3) hindurch direkt in den Innenraum der Nadelanordnung 49 vertikal hineinragen und auch noch vertikal durch ein Loch in der zweiten Führungsplatine 40 hindurch bis nahe an die Durchbrechung 36 der ersten Führungsplatine 30 oder in diese Durchbrechung 36 hinein oder in Sonderfällen sogar durch sie hindurch für das Inken geführt sein. Dies ist auch bei seitlicher Einführung der Kanüle 62 in die Nadelanordnung 49 möglich.

Der Kanüle 62 wird die aus ihr jeweils auszuspritzende Flüssigkeit von einem nicht dargestellten Vorratsbehälter aus zugeführt. Bspw. kann dieser Vorratsbehälter unter Druck stehen, so daß für das Inken eines Chips kurzzeitiges Öffnen eines Ventiles genügt. Auch andere Möglichkeiten bestehen. Bspw. kann kurzzeitiges Pumpen der jeweils auszuspritzenden Flüssigkeit vorgesehen sein.

Auch bei dem Prüfkopf 29 nach Fig. 3 sind die erste Führungsplatine 30 wie auch die zweite Führungsplatine 40 dünne Platten, deren Dicken viel kleiner als die Länge der Nadeln 39 ist. Auch erfolgt hier die axiale Federung der freien Kontaktenden 41 der Nadeln 39 ebenfalls zumindest im wesentlichen durch seitliches Ausbiegen der Nadeln zwischen der ersten Führungsplatine 30 und der ihre rückwärtigen Enden haltenden Platten 34, 45' .

Patentansprüche

1. Prüfeinrichtung zum Prüfen von Chips aufweisende Wafers auf elektrische Fehlerfreiheit der Chips, welche Prüfeinrichtung eine Nadelanordnung aufweist, deren Nadeln elastisch sind und metallische elektrische Leitfähigkeit aufweisen und dem gleichzeitigen Kontaktieren von an einem jeweils zu prüfenden Chip angeordneten Pads dienen, dadurch gekennzeichnet, daß die Nadeln (39) der Nadelanordnung ungefähr senkrecht zur Ebene des jeweils zu prüfenden Wafers (35) gerichtet sind, daß diese Nadeln (39) in entsprechend den von ihnen jeweils gleichzeitig zu kontaktierenden Pads (37) angeordneten Löchern einer ersten Führungsplatine (30) eines Prüfkopfes (29) oder dgl. axial gleitbar geführt sind, welche erste Führungsplatine (30) den dem Kontaktieren von Pads (37) dienenden freien Kontaktenden (41) der Nadeln (39) benachbart angeordnet ist, und daß die erste Führungsplatine (30) innerhalb der dem Kontaktieren jeweils eines Chips dienenden Nadelanordnung (49) einen Durchbruch (36) aufweist, welchem eine Vorrichtung (62) zum Inken fehlerhafter Chips zugeordnet ist.

2. Prüfeinrichtung nach Anspruch 1, dadurch gekennzeichnet, daß der Abstand der ersten Führungsplatine (30) von den freien Kontaktenden (41) der Nadeln (39) in deren Normalstellungen, in denen sie keine Pads (37) kontaktieren, im wesentlichen dem beim Prüfen auftretenden Federungsweg der freien Nadelkontaktenden entspricht oder diesem Federungsweg entspricht, vorzugsweise dieser Abstand max. 2 mm, besonders zweckmäßig max. 1 mm beträgt.

3. Prüfeinrichtung nach einem der vorhergehenden Ansprüche, dadurch gekennzeichnet, daß der Prüfkopf (29) oder dgl. eine einzige Kontaktnadelanordnung zum gleichzeitigen Kontaktieren der Pads eines einzigen Chips aufweist.

4. Prüfeinrichtung nach Anspruch 1 oder 2, dadurch gekennzeichnet, daß der Prüfkopf oder dgl. mindestens zwei unter sich gleiche Kontaktnadelanordnungen zum gleichzeitigen Kontaktieren einer entsprechenden Mehrzahl von Chips eines Wafers aufweist, wobei vorzugsweise vorgesehen sein kann, daß diese Nadelanordnungen aufeinanderfolgend an ein für die Prüfung eines einzelnen Chips ausgebildetes Testgerät der Prüfeinrichtung elektrisch anschließbar sind.

5. Prüfeinrichtung nach einem der vorhergehenden Ansprüche, dadurch gekennzeichnet, daß der Prüfkopf (29) oder dgl. mindestens eine zweite Führungsplatine (40) aufweist, in der die Nadeln (39) ebenfalls in Löchern axial gleitbar geführt sind.

6. Prüfeinrichtung nach einem der vorhergehenden Ansprüche, dadurch gekennzeichnet, daß die Nadeln (39) an einer Halteplatte (34) gehalten sind, die im Abstand von der ersten Führungsplatine (30) und, falls vorhanden, auch im Abstand von der mindestens einen zweiten Führungsplatine (40) angeordnet ist.

7. Prüfeinrichtung nach einem der vorhergehenden Ansprüche, dadurch gekennzeichnet, daß die Nadeln (39) im entspannten Zustand ungefähr gerade sind.

8. Prüfeinrichtung nach einem der vorhergehenden Ansprüche, dadurch gekennzeichnet, daß die Länge der Nadeln max. 40 mm, vorzugsweise ungefähr 8 bis 25 mm und ihr Durchmesser max. 0,3 mm, vorzugsweise max. 0,15 mm beträgt.

9. Prüfeinrichtung nach einem der vorhergehenden Ansprüche, dadurch gekennzeichnet, daß die Nadeln separate Nadeln (39) oder Bereiche (39) von viel längeren Drähten (42) sind.

10. Prüfeinrichtung nach einem der vorhergehenden Ansprüche, dadurch gekennzeichnet, daß die erste Führungsplatine (30) am Prüfkopf (29) unbeweglich angeordnet ist.

11. Prüfeinrichtung nach einem der Ansprüche 1 bis 9, dadurch gekennzeichnet, daß die erste Führungsplatine (30) am Prüfkopf oder dgl. in Längsrichtung der in ihrem Bereich befindlichen Abschnitte der Nadeln (39) beweglich angeordnet ist, vorzugsweise geradegeführt und vorzugsweise federnd beweglich.

12. Prüfeinrichtung nach Anspruch 11, dadurch gekennzeichnet, daß die freien Kontaktenden (41) der Nadeln (39) sich ständig innerhalb den diesen Nadeln zugeordneten Löchern der ersten Führungsplatine (30) befinden.

13. Prüfeinrichtung nach einem der vorhergehenden Ansprüche, dadurch gekennzeichnet, daß die erste Führungsplatine (30) und/oder die zweite Führungsplatine (40) für die Nadeln (39) Ausnehmungen aufweist, die jeweils einen kurzen lochförmigen Abschnitt zur axialen Führung der betreffenden Nadel und einen längeren, außer Kontakt mit der Nadel befindlichen Abschnitt, welcher ebenfalls lochförmig oder ein zum benachbarten Rand der Führungsplatine hin offener Schlitz (50''') ist, aufweist, vorzugsweise derart, daß die betreffende Führungsplatine (30;40) aus zwei Scheiben (51,52) besteht, von denen die eine Scheibe (52) als Positionierscheibe für die Nadeln dient und die lochförmigen kürzeren Durchbrüche (50") aufweist und die andere Scheibe eine die Positionierscheibe gegen Wölben sichernde starre Stützplatte (51) ist, die die längeren Abschnitte der Ausnehmungen aufweist.

14. Prüfeinrichtung nach einem der Ansprüche 5 bis 13, dadurch gekennzeichnet, daß zum schwachen Biegen der Nadeln (39) zwecks axialer Eigenfederung die Lochanordnung für sie in der zweiten Führungsplatine (40) etwas größer oder kleiner als die Lochanordnung in der ersten Führungsplatine (30) ist.

15. Prüfeinrichtung nach einem der Ansprüche 5 bis 13, dadurch gekennzeichnet, daß zum schwachen Biegen der Nadeln (39) zwecks axialer Eigenfederung die Lochanordnung für sie in der zweiten Führungsplatine (40) der Lochanordnung in der ersten Führungsplatine (30) ungefähr entspricht und zu ihr etwas seitlich versetzt angeordnet ist.

16. Prüfeinrichtung nach einem der vorhergehenden Ansprüche, dadurch gekennzeichnet, daß sie der Prüfung von Wafers dient, bei denen die durch die Nadelanordnung jeweils zu kontaktierenden Pads des betreffenden Chips in der jeweiligen Padreihe so angeordnet sind, daß die Mittelpunkte benachbarter Pads maximal 0,2 mm Abstand voneinander aufweisen.

17. Prüfeinrichtung nach einem der vorhergehenden Ansprüche, dadurch gekennzeichnet, daß die erste Führungsplatine (30) und, falls vorhanden, die mindestens eine zweite Führungsplatine (40) jeweils eine dünne Platte ist, deren Dicke viel kleiner als die Länge der Nadeln (39) ist, deren freien Kontaktenden (41) durch zumindest im wesentlichen außerhalb der oder den Führungsplatinen erfolgendes Ausbiegen der Nadeln axial federn können.

FIG.1

19    17    37    17    18

12    13    35    10

26    31

34    42    32

33    40    29    FIG.2

62

39    39

49

60    45    30    41

50    37    35

37    90    50    30

35

37

a    FIG.5

FIG.4    5    5

FIG.3

FIG.10

FIG.6

FIG.7

FIG8

FIG.9

Europäisches
Patentamt

EUROPÄISCHER RECHERCHENBERICHT

Nummer der Anmeldung

0233511

EP 87 10 1036

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 165 331 (IBM CORP.)<br><br>* Seite 1, Zeilen 6-11; Seite 4, Zeile 27 - Seite 5, Zeile 2; Seite 5, Zeilen 14-22; Seite 6, Zeile 33 - Seite 7, Zeile 3; Seite 8, Zeilen 23-31; Figuren 3,4,6 * | 1,4-7, 9,11, 12,15 | G 01 R 1/073 |
| A | | 8 | |
| | --- | | |
| Y | DE-A-2 006 653 (TIECO INC.)<br><br>* Seite 15, Zeile 34 - Seite 16, Zeile 15; Figur 4 * | 1,4-7, 9,11, 12,15 | |
| | --- | | RECHERCHIERTE SACHGEBIETE (Int. Cl.4) |
| A | JAHRBUCH DER DEUTSCHEN GESELLSCHAFT FÜR CHRONOMETRIE, Band 35, 1984, Seiten 69-75, Stuttgart, DE; G. KRÜGER: "Prüfung von elektrischen Baugruppen von Uhren"<br>* Seite 73, Zeilen 13-32; Figur auf Seite 73 * | 1,6,8-10,15 | G 01 R<br>H 01 R<br>H 05 K |
| | --- | | |
| A | DE-A-3 337 915 (FEINMETALL GmbH)<br>* Anspruch 1; Seite 38, Zeilen 12-16; Figuren 2,3,14 * | 1,9-11 | |
| | ----- | | |

Der vorliegende Recherchenbericht wurde für alle Patentansprüche erstellt.

| Recherchenort | Abschlußdatum der Recherche | Prüfer |
|---|---|---|
| DEN HAAG | 06-05-1987 | PENZKOFER,B. |

EPA Form 1503 03 82

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument